# EUROPEAN PATENT APPLICATION

(11) **EP 3 258 279 A1**
(43) Date of publication of application: **20.12.2017**
(21) Application number: 16174819.9
(22) Date of filing: 16.06.2016
(51) Int. Cl.: G01R 31/28

(54) **PRESSING DEVICE AND METHOD OF PRESSING A CARRIER AGAINST AN ELECTRICAL CONTACT UNIT**

(71) Applicant: Multitest elektronische Systeme GmbH, 83026 Rosenheim (DE)
(72) Inventor: Bursian, Andreas, 83064 Raubling (DE); Scholz, Thomas, 83043 Bad Aibling (DE); Joswig, Heiner, 83024 Rosenheim (DE)
(74) Representative: Dilg, Haeusler, Schindelmann Patentanwaltsgesellschaft mbH

(57) **Abstract**

A pressing device for pressing a carrier against an electrical contact unit comprises: a support plate for carrying the carrier and for pressing the carrier against the electrical contact unit by exerting an overall mechanical contact pressure on the support plate, wherein the support plate is deformable, so that a contact force is equal over the area of the support plate. A method of pressing a carrier against an electrical contact unit by a pressing device comprises: (a) providing a support plate for carrying the carrier and for pressing the carrier against the electrical contact unit, and (b) exerting an overall mechanical contact pressure on the support plate, wherein the support plate is deformable, so that that a contact force is equal over the area of the support plate.

## Description

### Field of invention

An embodiment of the invention relates to a pressing device for pressing a carrier against an electrical contact unit. Further, an embodiment of the invention relates to a method of pressing a carrier against an electrical contact unit by using a pressing device.

### Background of the invention

In order to test DUTs ("device under test") often flat carriers (such as clamping carriers or so called "strips") are used which carry a plurality of DUTs. Due to the extension of the carriers, which may be clamping carriers, strips, or the like, some of the DUTs are not appropriately tested. One reason may be that fabrication tolerances of the equipment cause differences in the contact force by which each of the DUTs is contacted to a mating contact socket.

### Summary of the Invention

There may be a need to amend the testing process and to overcome fabrication tolerances of the equipment.

In order to meet the need defined above a pressing device for pressing a carrier against an electrical contact unit and a method of pressing a carrier against an electrical contact unit by a pressing device are provided according to independent claims.

According to an embodiment of the invention a pressing device for pressing a carrier against an electrical contact unit comprises: a support plate for carrying the carrier and for pressing the carrier against the electrical contact unit by exerting an overall mechanical contact pressure on the support plate, wherein the support plate is deformable, so that a contact force is equal over the area of the support plate.

According to an embodiment of the invention a method of pressing a carrier against an electrical contact unit by a pressing device comprises: (a) providing a support plate for carrying the carrier and for pressing the carrier against the electrical contact unit, and (b) exerting an overall mechanical contact pressure on the support plate, wherein the support plate is deformable, so that that a contact force is equal over the area of the support plate.

The expression "pressing device" may denote a piece of equipment serving to act upon two bodies through steady pushing force so that the two bodies contact each other. In particular, the pressing device may regulate or adjust a pressing force by which a carrier and an electrical contact unit may be pressed against each other. The term "press" may denote to move for bringing into contact.

The term "carrier" may denote a device that carries a plurality of so called DUTs ("device under test") or electronic components which are to be tested by automated test equipment (ATE). E.g. carriers may be clamping carriers, strips, or the like.

The expression "electrical contact unit" may denote the electrical part of a unit serving to electrically contact to a plurality of DUTs on a carrier so that an electrical contact of the DUTs with a tester is established.

The expression "support plate" may denote a flat thin piece of material that carries a carrier and may be made up from one or more parts or plates. Due to the fact that the DUTs on the carrier are brought into electrical contact there is a mechanical force being exerted on both parts which may be called "overall mechanical contact pressure".

The term "deformable" may denote that the shape of a body is alterable. In particular, the shape of the support plate is alterable so that the main plane of the support plate is altered.

The expression "contact force" may denote the individual force being exerted on each individual DUT of the plurality of DUTs on the carrier. In particular, the electrical contact force may be equal or almost equal for each DUT which are regularly distributed over the area of the carrier.

A gist is that there are fabrication tolerances which are compensated if the support plate which is adapted to carry the carrier is deformable. By the deformation of the support plate which is a consequence of being deformable and being pressed in the direction towards the electrical contact unit the fabrication tolerances of the complete equipment including the electrical contact unit are compensated. This compensation results in an equal or more equal contact force being exerted over the area of the support plate. As a consequence, when the carrier is pressed against the electrical contact unit this is done in a more balanced and equal way for the carrier to, so that the contact force bringing the DUT into contact with a mating socket may be equal for each DUT. Hence, testing of the DUTs may be more uniform and more reliable.

According to an exemplary embodiment the pressing device further comprises a base plate and a plurality of actuators wherein the base plate supports the plurality of actuators and wherein the plurality of actuators support the support plate.

The expression "base plate" may denote a plate which is the bottom of something considered as its support. In particular, the base plate may be the support of the support plate without being arranged to be lower than the support plate. In particular, the base plate may have a higher stiffness than the support plate.

The term "actuator" may denote a mechanical device for moving or controlling something. There may be a "plurality" of actuators which are at least two. In particular, the actuators may control the distance between the base plate and the support plate. The actuators may be linear actuators. The stiffer base plate may thus deform the less stiff support plate by the use of the plurality of actuators. The base plate may thus be higher incapable of or highly resistant to bending or flexing in its main plane than the support plate.

The expressions that "the base plate supports the plurality of actuators" and "the plurality of actuators support the support plate" may denote that the actuators may extend between the base plate and the support plate. In particular, the plurality of actuators may extend vertically between the base plate and the support plate.

Actuators may allow for adjusting the contact force for a group of DUTs in a sub-area of the carrier or the support plate, respectively. So, if the compensation of the deformable support plate alone is not completely sufficient to reach the same contact force for each DUT, the actuators may amend this deformation to adjust the deformation of the support plate and of the carrier, respectively.

According to an exemplary embodiment of the pressing device at least one of the plurality of actuators is adjustable, so that a deformation of the support plate is adjustable.

The expression "the actuator is adjustable" may denote that the actuator is continuously individually to alter. In particular, at least two or even all actuators may be adjustable, so that the deformation of the support plate is adjustable. The expression that "the support plate is adjustable" may denote that the support plate is adaptable in that the grade of deformation of the main plane of the support plate is altered.

According to an exemplary embodiment of the pressing device the plurality of actuators are arranged in a matrix form in a main plain of the support plate.

The expression that the actuators are "arranged in a matrix form in a main plain of the support plate" may denote that the actuators are distributed over the area of the support plate and support the support plate so that the distances between neighboring actuators are equal or almost equal. A matrix may be at least a 2x1-matrix.

According to an exemplary embodiment of the pressing device at least one of the plurality of actuators is spherically seated by a ball and socket joint towards at least one of the base plate or the support plate.

The expression "spherically seated by a ball and socket joint" may denote a joint in which a ball moves within a socket so as to allow rotary motion in every direction within certain limits. In particular, both ends of at least one or each of the actuators are spherically seated by a ball and socket joint, so that there is a rotary motion allowed which compensates shifting of the support plate relative to the base plate. By the ball and socket joints the complete arrangement of the support plate, the actuators, and the base plate may be prevented from being damaged if the actuators alter their lengths.

According to an exemplary embodiment of the pressing device at least one of the plurality of actuators comprises a piezo linear actuator.

The actuators may be linear actuators wherein the motion of the linear actuators may be perpendicular to the main plane of the support plate and the base plate. In particular, the piezo linear actuators may be driven by a piezoelectric force.

According to an exemplary embodiment of the pressing device at least one piezo linear actuator measures an exerted force and the at least one piezo linear actuator is controlled to adjust the exerted force after the measurement.

The piezo linear actuator may be adapted to measure an exerted force. In particular, the force being measured may be exerted on the piezo linear actuator itself. After measuring the exerted force on the piezo linear actuator the force being exerted by the piezo linear actuator may be adjusted by altering the length of the piezo linear actuator. Measuring the exerted force on the piezo linear actuator and adjusting the force being exerted by the piezo linear actuator may lead to a control loop. By the control loop the pressing device may be adjusted so that a test of the DUTs is even more uniform and more reliable in that the contact force for each of the DUTs may be equal.

According to an exemplary embodiment of the pressing device a pushing device moves the base plate and exerts the overall mechanical contact force on the support plate.

The expression "pushing device" may denote a piece of equipment for pressing something against something with force in order to drive or impel. In particular, the pushing device moves the base plate which again moves the support plate, since the base plate and the support plate are coupled by the plurality of actuators. In particular, the pushing device exerts the overall mechanical contact force which is then adjusted by the linear actuators over the area of the support plate. By pressing the support plate in the direction towards the electrical contact unit the carrier may be pressed against the electrical contact unit.

According to an exemplary embodiment of the pressing device the plurality of actuators are embedded in a thermal insulation which is arranged between the support plate and the base plate.

The expression "embedded in a thermal insulation" may denote that the thermal insulation surrounds the plurality of actuators without harming the function of the actuators.

According to an exemplary embodiment the pressing method comprises providing a base plate and a plurality of actuators wherein the base plate supports the plurality of actuators and wherein the plurality of actuators support the support plate.

According to an exemplary embodiment the pressing method comprises adjusting the actuators so that a deformation of the support plate is adjusted.

According to an exemplary embodiment the pressing method the actuators are arranged in a matrix form in a main plain of the support plate.

According to an exemplary embodiment the pressing method at least one of the plurality of actuators is spherically seated by a ball and socket joint towards at least one of the base plate or the support plate.

According to an exemplary embodiment the pressing method comprises at least one of the plurality of actuators comprising a piezo linear actuator.

According to an exemplary embodiment the pressing method comprises (a) measuring an exerted force by the at least one piezo linear actuator and (b) controlling the piezo linear actuator so the exerted force is adjusted after the measurement.

According to an exemplary embodiment the pressing method further comprises (a) moving the base plate by means of a pushing device and (b) exerting an overall compressive force on the support plate by the pushing device.

According to an exemplary embodiment the pressing method the plurality of actuators are embedded in a thermal insulation which is arranged between the support plate and the base plate.

### Brief Description of the Drawing

- Fig.1: shows a schematic illustration of automated test equipment
- Fig.2: shows a perspective view of a carrier
- Fig.3: shows a schematic view of a contacting unit
- Fig.4: shows a perspective view of a socket plate
- Fig.5: shows a perspective view of a support plate
- Fig.6: shows a cross-sectional view of a pressing device
- Fig.7: shows a detail of a cross-sectional view of a pressing device

### Detailed Description of the Drawing

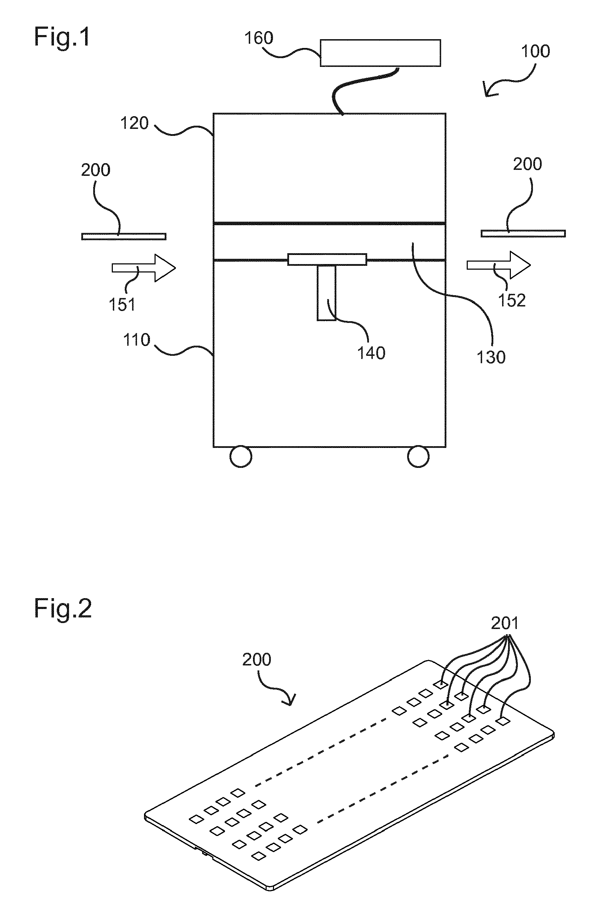

Fig. 1 shows automated test equipment 100 which comprises a handler 110, a test head 120 and a tester 160. The handler 110 is adapted for receiving 151 a carrier 200 first and then for removing 152 the carrier 200 after a test. The tester 160 is adapted to run a test routine and to evaluate the test results. A test head 120 is located between the handler 110 and the tester 160 so that a contacting unit 130 may be electrically coupled with numerous carriers 200 and with the tester 160. In order to contact the carrier 200 with the contacting unit 130 the carrier 200 may be lifted and lowered by a pushing device 140.

As shown in Fig. 2 the carrier 200 comprises a plurality of electronic components 201 which are aligned on the carrier 200 in a matrix form. Hence, the expression that "the carrier 200 is tested" means more precisely that the plurality of electronic components 201 on the carrier 200 are contacted to the contacting unit 130 and are individually tested by the test routine running on the tester 160.

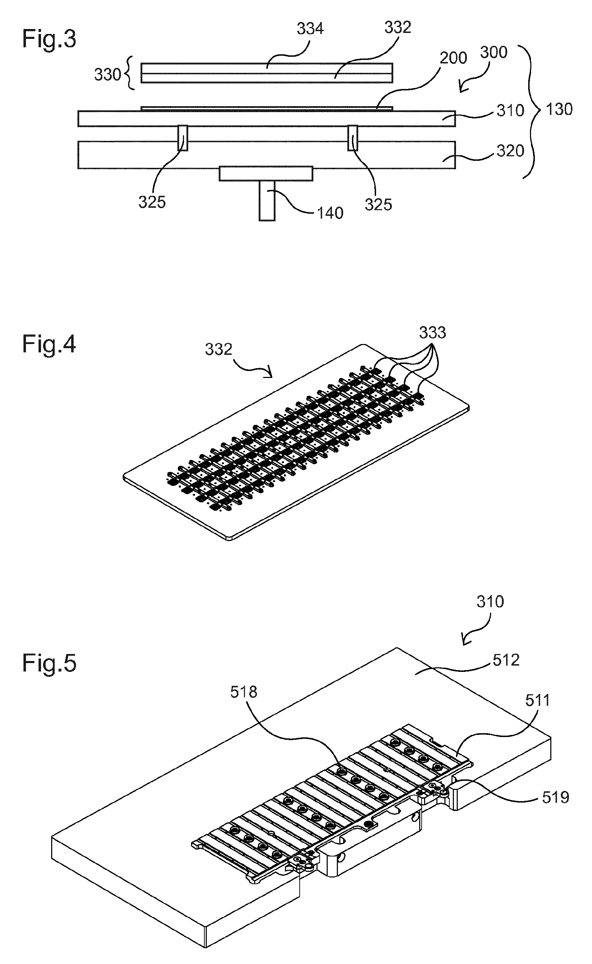

Fig. 3 shows the contacting unit 130 which may comprise an electrical contact unit 330 and a pressing device 300. The pressing device 300 may comprise a support plate 310 which may be deformable when being pressed against a contact socket plate 332 of the electrical contact unit 330. The electrical contact unit 330 may comprise the contact socket plate 332 and a so called DUT board 334 which is electrically coupled to the tester 160 (see Fig. 1). The deformable support plate 310 may support the carrier 200 which is then pressed against the contact socket plate 332. The pressing device 300 may further comprise a base plate 320 on which a plurality of actuators 325 are arranged. By means of the plurality of actuators 325 the deformation of the support plate 310 may be adapted so that the force being exerted on the support plate 310 and on the carrier 200 is equal over the area of the support plate 310 and the carrier 200, respectively. The overall pressing force is exerted by the pushing device 140 which supports and lifts the base plate 320. So, the overall pressing force is adjusted by the plurality of actuators 325 in a way that the contact force for the plurality of electronic components 201 (see Fig. 2) is equal or almost equal. Even if the contacting unit 130 may be named with this one expression usually the pressing device 300 is regarded as a part of the handler and the electrical contacting unit 330 may be regarded as a part of the test head 120.

As shown in Fig. 4 the contact socket plate 332 may comprise a plurality of contact sockets 333 which are arranged in the same matrix form as the electronic components 201 are arranged on the carrier 200. So, each one of the plurality of contact sockets 333 may mate with the respective one of the plurality of electronic components 201 of the carrier 200.

Fig. 5 shows that the support plate 310 may comprise an upper insulation plate 512 and a conversion kit plate 511 which may be changed when different types of carriers 200 are used. There may be a plurality of suction devices 518 integrated on the conversion kit plate 511, which enable that the carrier 200 rests in position when being moved. Adjacent to the conversion kit plate 519 the support plate 310 may comprise fiducial elements 519 by means of which the carrier 200 may be aligned in the directions perpendicular to the lifting and lowering direction of the pushing device 140..

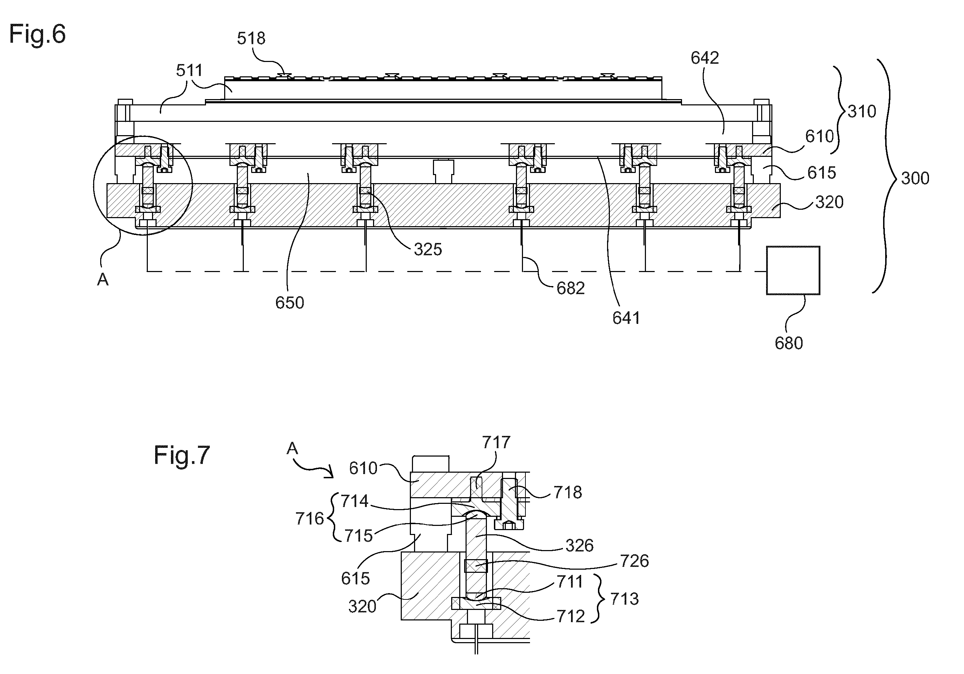

Fig. 6 shows a cross-sectional view of the pressing device 300. The pressing device 300 may comprise the support plate 310 which supports the carrier 200. The support plate 310 may comprise the conversion kit plate 511 which may be penetrated by a plurality of suction devices 518. The conversion kit plate 511 may be mounted on the tempering plate 511 which enables to temper the carrier 200 via the conversion kit plate 511.

The support plate 310 may further comprise a heating plate 610 which transports the heat from a heating foil 641 to the conversion kit plate 511. The heating plate 610 may therefore be arranged between the heating foil 641 and the conversion kit plate 511. The support plate 310 may additionally comprise a temperature and stiffener plate 642 which may be arranged between the heating plate 610 and the conversion kit plate 511 so that the heat may efficiently be lead to the conversion kit plate 511 and to the carrier 200 (see Fig. 3). Guiding pins 615 may be arranged in an edge area of the support plate 310 to center the support plate 310 on the base plate 320 and to mount the different plates to each other. A plurality of actuators 325 may be arranged between the base plate 320 and the heating plate 610 or the support plate 310, respectively. The support plate 310 may be formed from one piece or the support plate 310 may comprise several individual plates arranged in a sandwiched form as described above. A thermal insulation 650 may be arranged between the support plate 310 or heating foil 641, respectively and the base plate 320 so that heat loss is prevented for the pressing device 300. The plurality of actuators 325 may penetrate the thermal insulation 650. The plurality of actuators 325 may be arranged in a matrix form over the area of the support plate 310.

The actuators 325 which may comprise piezo linear actuators 326 (see Fig.7) support the support plate 310 so that any force exerted by the piezo linear actuators 326 may bend the support plate 310 having a lower stiffness than the base plate 320. A control device 680 may be coupled by control wiring 682 with each of the actuators or piezo actuators 325, respectively, so that the piezo actuators may each be controlled individually. The force exerted on each of the piezo actuators 325 may be measured, and then, depending on the measurement the force exerted by the piezo actuators 325 may be adapted.

Fig. 7 shows detail A of Fig. 6. The piezo linear actuator 326 is arranged between the base plate 320 and the heating plate 610 with a ball and socket joint 713, 716 on each end of the piezo linear actuator 326. The first ball and socket joint 713 coupling the one end of the piezo linear actuator 326 with the base plate 320 may comprise a first joint head 711 at the end of the piezo linear actuator 326 and a first joint socket 712 mounted on the base plate 320. The second ball and socket joint 716 may comprise a second joint head 714 at the other end of the piezo linear actuator 326 and a second joint socket 715 being mounted on the heating plate 610 so that the piezo linear actuator 326 is coupled with the heating plate 610 by the second ball and joint head 716. A centering pin 717 extending from the second joint socket 715 into the heating plate 610 may center the second joint socket 715. The centering pin 717 may further be secured by a screw 718 connecting the second joint socket 715 and the heating plate 610.

The first and second ball and socket joints 713, 716 allow for a slight movement of the base plate 320 and the heating plate 610 relative to each other. Further, the first and second ball and socket joints 713, 716 allow for a thermal decoupling of the base plate 320 and the heating plate 610. The guiding pin 615 mounts the heating plate 610 on the base plate 320. An electric insulation 726 may be arranged around the middle part of the piezo linear actuator 326 within an opening of the base plate 320 so that there is no electric loss if there is any movement of the piezo linear actuator 326 relative to the base plate 320.

## Claims

1. A pressing device (300) for pressing a carrier (200) against an electrical contact unit (330), the pressing device (300) comprising:
a support plate (310) for carrying the carrier (200) and for pressing the carrier (200) against the electrical contact unit (330) by exerting an overall mechanical contact pressure on the support plate (310), wherein the support plate (310) is deformable, so that a contact force is equal over the area of the support plate (310).

2. The pressing device (300) according to claim 1, further comprising
a base plate (320) and a plurality of actuators (325), wherein
the base plate (320) supports the plurality of actuators (325) and wherein the plurality of actuators (325) support the support plate (310).

3. The pressing device (300) according to claim 2, wherein
at least one of the plurality of actuators (325) is adjustable, so that a deformation of the support plate (310) is adjustable.

4. The pressing device (300) according to at least one of the claims 2 or 3, wherein
the plurality of actuators (325) are arranged in a matrix form in a main plain of the support plate (310).

5. The pressing device (300) according to at least one of the claims 2 to 4, wherein
at least one of the plurality of actuators (325) is spherically seated by a ball and socket joint (713), (716) towards at least one of the base plate (320) or the support plate (310).

6. The pressing device (300) according to at least one of the claims 2 to 5, wherein
at least one of the plurality of actuators (325) comprises a piezo linear actuator (326).

7. The pressing device (300) according to claim 6, wherein
the at least one piezo linear actuator (326) measures an exerted force and wherein the at least one piezo linear actuator (326) is controlled to adjust the exerted force after the measurement.

8. The pressing device (300) according to at least one of the claims 1 to 5, further comprising
a pushing device (140) which moves the base plate (320) and exerts the overall mechanical contact force on the support plate (200).

9. The pressing device (300) according to at least one of the claims 2 to 8, wherein
the plurality of actuators (325) are embedded in a thermal insulation (650) which is arranged between the support plate (310) and the base plate (320).

10. A method of pressing a carrier (200) against an electrical contact unit (330) by a pressing device (300), wherein method comprises:
providing a support plate (310) for carrying the carrier (200) and for pressing the carrier (200) against the electrical contact unit (330), and
exerting an overall mechanical contact pressure on the support plate (310), wherein
the support plate (310) is deformable, so that that a contact force is equal over the area of the support plate (310).

11. The method of pressing a carrier (200) against an electrical contact unit (330) according to claim 10, further comprising
providing a base plate (320) and a plurality of actuators (325),
wherein
the base plate (320) supports the plurality of actuators (325) and wherein the plurality of actuators (325) support the support plate (310).

12. The method of pressing a carrier (200) against an electrical contact unit (330) according to claim 11, further comprising
adjusting at least one of the plurality of actuators (325), so that a deformation of the support plate (310) is adjusted.

13. The method of pressing a carrier (200) against an electrical contact unit (330) according to at least one of the claims claim 11 or 12, wherein
at least one of the plurality of actuators (325) comprises a piezo linear actuator (326).

14. The method of pressing a carrier (200) against an electrical contact unit (330) according to claim 13, further comprising
measuring an exerted force by the at least one piezo linear actuator (326) and
controlling the piezo linear actuator (326) so the exerted force is adjusted after the measurement.

15. The method of pressing a carrier (200) against an electrical contact unit (330) according to at least one of the claims 10 to 14, further comprising moving the base plate (320) by means of a pushing device (140) and exerting the overall mechanical contact pressure on the support plate (200) by the pushing device (140).
